(19) Europäisches Patentamt
European Patent Office
Office européen des brevets

(11) **EP 3 474 440 B1**

(12) **FASCICULE DE BREVET EUROPEEN**

(45) Date de publication et mention
de la délivrance du brevet:
**22.07.2020 Bulletin 2020/30**

(51) Int Cl.:
***H02S 50/10*** *(2014.01)*

(21) Numéro de dépôt: **18199375.9**

(22) Date de dépôt: **09.10.2018**

(54) **PROCÉDÉ DE DÉTECTION DE DÉFAUTS DANS UN MODULE PHOTOVOLTAÏQUE**

FEHLERERKENNUNGSVERFAHREN FÜR PHOTOVOLTAIKMODUL

METHOD TO DETECT FAULTS IN A PHOTOVOLTAIC MODULE

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.10.2017 FR 1760003**

(43) Date de publication de la demande:
**24.04.2019 Bulletin 2019/17**

(73) Titulaire: **Commissariat à l'Énergie Atomique
et aux Énergies Alternatives
75015 Paris (FR)**

(72) Inventeurs:
• **HA, Duy Long
73000 CHAMBERY LE VIEUX (FR)**
• **AL SHAKARCHI, Franck
73160 SAINT-SULPICE (FR)**

(74) Mandataire: **GIE Innovation Competence Group
310, avenue Berthelot
69372 Lyon Cedex 08 (FR)**

(56) Documents cités:
**WO-A1-2016/189052      US-A1- 2016 245 860**

**Description**

**Domaine technique de l'invention**

La présente invention se rapporte à un procédé de détection de défauts dans un module photovoltaïque.
L'invention concerne également un système de détection configuré pour mettre en œuvre ledit procédé de détection.

**Etat de la technique**

Une architecture photovoltaïque comporte en règle générale plusieurs chaînes de modules photovoltaïques (appelés également panneaux photovoltaïques ou panneaux solaires) connectées en parallèle. Dans chaque chaîne, les modules photovoltaïques sont connectés en série. Chaque module photovoltaïque comporte plusieurs cellules photovoltaïques connectées en série, sous forme de rangées de cellules. Chaque cellule photovoltaïque est destinée à convertir une énergie solaire en une énergie électrique. Les chaînes de modules photovoltaïques sont reliées à un convertisseur, par exemple un onduleur. Ce convertisseur permet de convertir la tension continue fournie par chaque chaîne de modules en une tension alternative. Le rôle du convertisseur est également de déterminer un point de fonctionnement pour lequel la puissance délivrée par une chaîne de modules photovoltaïque est maximale (point de fonctionnement maximal désigné MPP pour "Maximum Power Point").
Il est nécessaire de surveiller l'état de fonctionnement de chaque module photovoltaïque d'une chaîne afin de repérer un éventuel défaut au niveau d'un module et d'y pallier le plus rapidement possible. Selon les cas, le défaut pourra être de différentes natures, notamment permanent s'il s'agit d'un problème matériel ou temporaire s'il s'agit par exemple de la présence d'un ombrage ou d'une poussière sur le module.
Il existe différentes solutions pour surveiller l'état de fonctionnement d'un module photovoltaïque.
Certaines solutions utilisent des capteurs de courant et de tension pour vérifier le comportement électrique du module. Le document WO2015/118608 décrit une telle méthode basée sur la courbe I-V d'une cellule photovoltaïque. Cette solution est cependant très couteuse si on souhaite l'installer sur l'ensemble des modules d'une architecture.
D'autres solutions utilisent des capteurs de température. C'est le cas par exemple du brevet US6512458B1 et de la demande US2011/088744A1 qui décrivent des solutions dans lesquelles des capteurs de température sont destinés à mesurer la température au niveau des diodes de contournement pour en déduire un éventuel défaut au niveau des cellules contournées. La demande de brevet US2011/316343A1 décrit pour sa part un module photovoltaïque comportant plusieurs cellules interconnectées dans laquelle chaque cellule est associée à une unité de contrôle qui comporte un capteur de puissance et un capteur de température pour surveiller l'intégrité de la cellule.
Enfin, d'autres solutions utilisent des caméras thermiques pour repérer des éventuels points chauds sur les modules après une stimulation électrique. Les solutions de détection par imagerie thermique sont très contraignantes et peu fiables, notamment pour détecter des défauts temporaires ou intermittents. De plus, elles obligent souvent les opérateurs de maintenance à passer devant chaque module avec la caméra thermique puis à interpréter l'image obtenue, ce qui peut s'avérer difficile à mettre en œuvre.
La demande de brevet WO2016/189052A1 décrit également un procédé de détection de défaut dans un module photovoltaïque.
Il existe un besoin de disposer d'un procédé simple, fiable, peu couteux qui permette de surveiller l'état d'un module photovoltaïque et qui, en cas de détection de la présence d'un défaut, de déterminer quel est le type de défaut.

**Exposé de l'invention**

Le procédé de l'invention permet de répondre à ce besoin.
Ce procédé permet une détection de défaut dans un module photovoltaïque qui comporte plusieurs cellules photovoltaïques connectées entre elles et une ou plusieurs diodes de contournement, chaque diode de contournement étant configurée pour contourner une ou plusieurs cellules photovoltaïques dudit module photovoltaïque, ce procédé comportant les étapes suivantes :

- Détermination d'une matrice de températures du module photovoltaïque, ladite matrice étant obtenue après découpage du module en plusieurs zones thermiques et affectation d'une température à chaque zone thermique ;
- Détection d'au moins une zone thermique chaude parmi lesdites plusieurs zones du module ;
- Détermination d'un rapport de surface entre la surface de la zone thermique chaude détectée et la surface totale du module ;
- Première comparaison dudit rapport de surface avec un coefficient fonction du nombre de diodes de contournement présentes dans le module ;
- Détermination du type de défaut à partir du résultat obtenu lors de ladite première comparaison.

Selon une particularité, ladite première comparaison consiste à comparer ledit rapport de surface avec ledit coefficient égal à 1/N dans lequel N correspond au nombre de diodes de contournement présentes dans le module en vue d'obtenir une première option ou une deuxième option selon ledit résultat de la comparaison.
Selon une autre particularité, dans ladite première option, le procédé comporte des étapes de :

- Détermination d'une différence de température entre ladite température moyenne du module photovoltaïque et une température de référence obtenue sur un module photovoltaïque de référence ;
- Deuxième comparaison de ladite différence de température avec une valeur seuil ;
- Détermination du type de défaut à partir du résultat de ladite deuxième comparaison entre une défaillance globale du module et un défaut de type point chaud.

Selon une autre particularité, lorsque le défaut est de type point chaud, le procédé consiste à déterminer une perte de production énergétique du module photovoltaïque occasionnée par ledit défaut de type point chaud.

Selon une autre particularité, dans ladite deuxième option, il comporte des étapes de :

- Obtention d'une température maximale de ladite zone thermique chaude détectée ;
- Troisième comparaison de ladite température maximale avec une valeur seuil supérieure à une valeur moyenne des températures dudit module de référence ;
- Détermination du type de défaut à partir du résultat de ladite troisième comparaison entre une défaillance globale du module et un autre type de défaut.

Selon une autre particularité, lorsqu'il s'agit d'un autre type de défaut, il comporte une étape de détermination du nombre de diodes de contournement en défaut.

L'invention concerne également un système de détection de défaut dans un module photovoltaïque qui comporte plusieurs cellules photovoltaïques connectées entre elles et une ou plusieurs diodes de contournement, chaque diode de contournement étant configurée pour contourner une ou plusieurs cellules photovoltaïques dudit module photovoltaïque, caractérisé en ce qu'il comporte :

- Un module de détermination d'une matrice de températures du module photovoltaïques, ladite matrice étant obtenue après découpage du module en plusieurs zones thermiques et affectation d'une température à chaque zone thermique ;
- Un module de détection d'au moins une zone thermique chaude parmi lesdites plusieurs zones du module ;
- Un module de détermination d'un rapport de surface entre la surface de la zone thermique chaude détectée et la surface totale du module ;
- Un premier module de comparaison configuré pour mettre en oeuvre une comparaison dudit rapport de surface avec un coefficient fonction du nombre de diodes de contournement présentes dans le module ;
- Un module de détermination du type de défaut à partir du résultat obtenu par ledit premier module de comparaison.

Selon une particularité, ledit premier module de comparaison est configuré pour comparer ledit rapport de surface avec ledit coefficient égal à 1/N dans lequel N correspond au nombre de diodes de contournement présentes dans le module en vue d'obtenir une première option ou une deuxième option selon ledit résultat de la comparaison.

Selon une autre particularité, dans ladite première option, il est configuré pour exécuter :

- Un module de détermination d'une différence de température entre une température moyenne du module photovoltaïque et une température de référence obtenue sur un module photovoltaïque de référence ;
- Un deuxième module de comparaison configuré pour mettre en oeuvre une comparaison de ladite différence de température avec une valeur seuil ;
- Un module de détermination du type de défaut à partir du résultat de ladite comparaison mise en œuvre par ledit deuxième module de comparaison, entre une défaillance globale du module et un défaut de type point chaud.

Selon une autre particularité, lorsque le défaut est de type point chaud, le système est configuré pour exécuter un module de détermination d'une perte de production énergétique du module photovoltaïque occasionnée par ledit défaut de type point chaud.

Selon une autre particularité, dans ladite deuxième option, le système est configuré pour exécuter :

- Un module d'obtention d'une température maximale de ladite zone chaude détectée ;
- Un troisième module de comparaison configuré pour mettre en œuvre une comparaison de ladite température maximale avec une valeur seuil supérieure à une valeur moyenne des températures dudit module de référence ;
- Un module de détermination du type de défaut à partir du résultat de ladite comparaison mise en œuvre par ledit troisième module de comparaison, entre une défaillance globale du module et un autre type de défaut.

Selon une autre particularité, lorsqu'il s'agit d'un autre type de défaut, le système est configuré pour exécuter un module de détermination du nombre de diodes de contournement en défaut.

**Brève description des figures**

D'autres caractéristiques et avantages vont apparaître dans la description détaillée qui suit faite en regard des dessins annexés dans lesquels :

- La figure 1 représente de manière schématique une architecture photovoltaïque classique ;
- La figure 2 représente de manière schématique la structure simplifiée d'un module photovoltaïque auquel est associé le système de détection de l'invention ;
- La figure 3 représente un organigramme illustrant l'algorithme de détection exécuté par le système de détection ;
- Les figures 4A à 4C illustrent différents cas de dysfonctionnement sur un module photovoltaïque ;

**Description détaillée d'au moins un mode de réalisation**

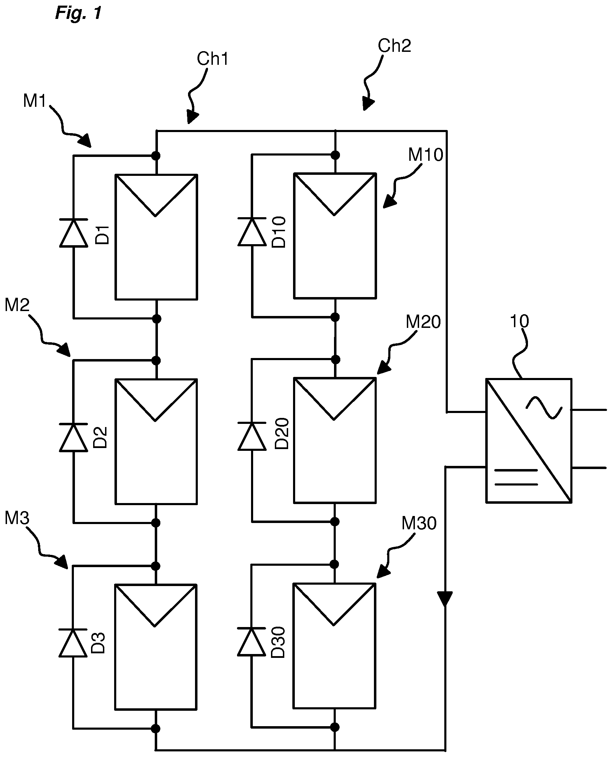

En référence à la figure 1, une architecture photovoltaïque présente classiquement les particularités d'agencement et de fonctionnement suivantes :

- Plusieurs chaînes Ch1, Ch2 de modules photovoltaïques (appelés également panneaux photovoltaïques ou panneaux solaires) sont connectées en parallèle (deux chaînes sur la figure 1).
- Chaque chaîne de modules photovoltaïques comporte plusieurs modules photovoltaïques connectés en série (M1-M3 pour la chaine Ch1 et M10-M30 pour la chaîne Ch2).
- Un module photovoltaïque (référencé de manière générale Mi dans la suite du texte) comporte plusieurs cellules photovoltaïques (non représentées) connectées en série. Les cellules photovoltaïques sont réparties en plusieurs rangées. Une rangée peut comporter une ou plusieurs cellules photovoltaïques.
- Chaque cellule photovoltaïque est destinée à convertir une énergie solaire en une énergie électrique.
- Un convertisseur, par exemple un onduleur 10, comportant plusieurs bras de commutation à base de transistors, est destiné à convertir une tension continue fournie par chaque chaîne de modules en une tension alternative.
- Des moyens de commande, intégrés ou non au convertisseur, sont aptes à commander l'onduleur pour effectuer la conversion de tension.
- Chaque module comporte avantageusement des diodes anti-retours (non représentées) positionnées de manière adaptée, par exemple en série avec les modules de chaque chaîne.
- Chaque module comporte avantageusement des diodes de contournement (dites de "bypass") pour contourner chacune une rangée de cellules distinctes d'un module si une cellule de cette rangée était en défaut. Sur la figure 1, une diode de contournement est représentée par module (les diodes sont référencées D1, D2, D3, D10, D20, D30 sur la figure 1).

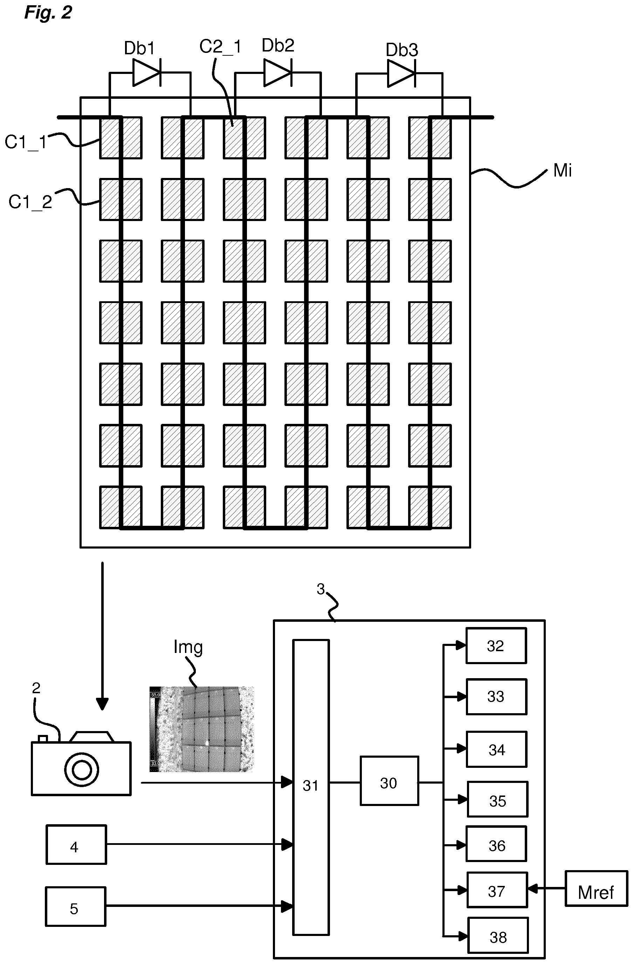

En référence à la figure 2, dans chaque module, on a l'agencement suivant :

- Les cellules photovoltaïques sont organisées en plusieurs rangées ou groupes. Sur la figure 2 deux colonnes de cellules forment une rangée de cellules. Sur cette figure, la cellule référencée C1_1 correspond à la première cellule de la première rangée et la cellule référencée C1_2 correspond à la deuxième cellule de la première rangée. La cellule référencée C2_1 correspond à la première cellule de la deuxième rangée. Dans la suite de la description, chaque cellule est référencée de manière générale, Cx, avec x correspondant à la référence de la cellule.
- Sur la figure 2, une diode de contournement Db1, Db2, Db3 distincte est associée à chaque rangée de cellules représentée. Sur la figure 2, une rangée de cellules comporte plusieurs cellules mais elle pourrait ne comporter qu'une seule cellule.

L'invention vise notamment à détecter la présence d'un défaut dans un module photovoltaïque Mi en fonctionnement et à déterminer le type de défaut détecté. Ce procédé est mis en œuvre grâce à un système de détection adapté. Dans la suite de la description, le module photovoltaïque faisant l'objet de l'évaluation est désigné "module surveillé". Chaque zone thermique chaude est désignée Zh.

On peut notamment distinguer trois types de défauts sur un module photovoltaïque :

- 1er type : Défaut de type point chaud (ou "hot spot"). Ce type de défaut peut être occasionné par une fracture au niveau d'une cellule du module, par un ombrage, par une cellule en court-circuit, par une rupture au niveau des rubans d'interconnexion liant les cellules entre elles, par une délamination ou la présence de corrosion.
- 2ème type : Défaut consistant en la défaillance d'une ou plusieurs diodes de contournement.
- 3ème type : Module complet en dysfonctionnement. Ce défaut peut être occasionné par une fracture de plusieurs cellules, par l'effet PID ("Potential Induced dégradation") ou par la défaillance de l'ensemble des diodes de contournement. Dans cette situation, la perte énergétique du module photovoltaïque est égale à 100%.

En référence à la figure 2, le système de détection comporte des moyens d'acquisition de données représentatives de valeurs de températures au niveau du module photovoltaïque en fonctionnement. Ces moyens d'acquisition peuvent être une caméra thermique 2 destinée à prendre une image thermique Img de la surface du module photovoltaïque surveillé. Les moyens d'acquisition peuvent être des capteurs de température répartis au niveau de chaque cellule ou d'un ensemble de cellules photovoltaïques du module surveillé et positionnés de manière adaptée sur la face arrière du module. Toute autre solution pourrait être employée. Sur la figure 2, une caméra thermique est représentée et fournit une image Img thermique du module à l'unité centrale 3. La caméra peut être portée par un opérateur ou installée sur un drone destiné à survoler l'installation photovoltaïque.

Le système de détection comporte une unité de traitement 3 ou calculateur. Cette unité de traitement 3 peut être connectée aux moyens d'acquisition employés, tels que la caméra thermique 2, pour recevoir lesdites données (l'image Img). Toute solution de connexion de type filaire ou sans-fil peut être envisagée.

L'unité de traitement 3 comporte un microprocesseur 30 et des moyens de mémorisation. Il pourra s'agir d'un ordinateur portable ou d'un terminal mobile. La caméra thermique 2 peut être associée à l'unité de traitement 3 dans un même boîtier.

Le système peut comporter un dispositif de mesure 4 de la température ambiante ainsi qu'un dispositif de mesure 5 de l'irradiance. Ces données peuvent être utiles à l'unité de traitement pour établir des diagnostics plus évolués.

L'unité de traitement 3 peut comporter un module de communication 31 configuré pour communiquer avec la caméra thermique 2 et les dispositifs 4, 5.

L'unité de traitement 3 comporte des modules logiciels exécutés par le microprocesseur 30 pour notamment mettre en œuvre le procédé de détection de défaut de l'invention.

L'unité de traitement 3 peut comporter un module de découpage 32 ou de décomposition d'une image thermique. Ce module est exécuté sur demande par le microprocesseur 30 lorsqu'une image thermique a été acquise.

Le découpage peut consister à décomposer l'image thermique en plusieurs zones. Il est réalisé par un traitement d'image mis en œuvre par l'unité de traitement. Chaque zone de température est caractérisée par une température propre qui est uniforme ou quasi-uniforme sur toute la zone. Deux zones thermiques adjacentes présentent entre elles un écart de température suffisant, par exemple supérieur à un certain seuil (par exemple 10°C). Par quasi-uniforme, on veut dire que la température peut varier d'un point à un autre de la zone thermique, mais que la différence de température entre deux points d'une même zone reste toujours inférieure audit seuil. A chaque zone thermique est ensuite associée une température déterminée représentative de la température de la zone. Cette température affectée à chaque zone peut être une température moyenne déterminée à partir de toutes les températures de la zone.

Le même découpage en plusieurs zones thermiques peut bien entendu être réalisé à l'aide des données fournies par les capteurs de température.

L'unité de traitement 3 peut comporter un module de détermination 33 des surfaces respectives des différentes zones thermiques découpées.

L'unité de traitement 3 peut comporter un module de détermination 34 d'une matrice de températures, la matrice de températures consistant, après découpage du module surveillé en plusieurs zones, à affecter une température à chaque zone.

L'unité de traitement 3 peut comporter un module de détection 35 de chaque zone thermique chaude Zh à partir de ladite matrice.

Une zone thermique chaude Zh correspond à une zone pour laquelle la température diffère de manière conséquente par rapport aux températures des autres zones du module. Par zone thermique chaude Zh, on entend une zone thermique pour laquelle la température dépasse un certain seuil. Ce seuil sera par exemple égal à une température de référence à laquelle est ajouté un delta de température.

L'unité de traitement 3 peut comporter un module d'obtention 36 de la température de référence Tref à partir d'un module désigné comme module de référence Mref.

La température de référence Tref est la température d'un module de référence Mref considéré comme sain, c'est-à-dire sans défaut en fonctionnement. Le module de référence Mref est un module photovoltaïque analogue au module photovoltaïque surveillé (c'est-à-dire avec les mêmes caractéristiques techniques) mais non défectueux. Il est avantageusement présent dans la même architecture photovoltaïque que le module surveillé. La température de référence peut être obtenue d'une manière identique à celle utilisée pour le module surveillé, c'est-à-dire à partir d'une image thermique du module et/ou de capteurs de température positionnés sur la face arrière du module de référence. Les données de température du module de référence peuvent être envoyées à l'unité de traitement 3 qui peut alors calculer la température de référence à l'aide du module adapté 36. Cette température de référence Tref correspond à la température moyenne du module de référence Mref.

L'unité de traitement 3 comporte un module de détermination 37 du type de défaut présent dans un module photovoltaïque Mi, qui est par exemple exécuté après détection d'au moins une zone thermique chaude Zh au niveau du module. Ce module de détection du type de défaut peut notamment utiliser les autres modules évoqués ci-dessus.

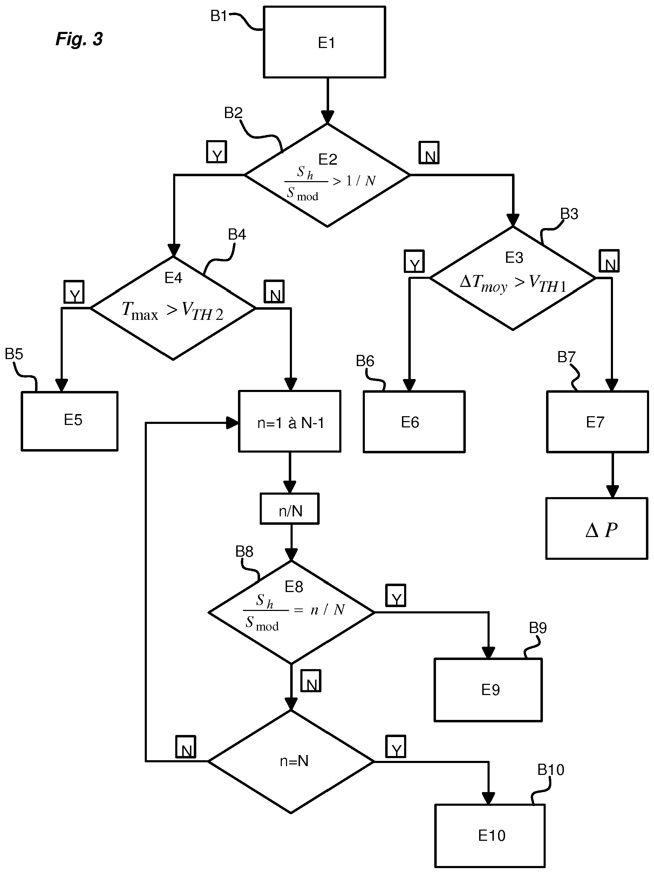

Le module de détermination du type de défaut du module photovoltaïque Mi surveillé s'appuie sur l'algorithme représenté sur la figure 3. Cet algorithme est exécuté par le microprocesseur 30 lorsqu'une zone thermique chaude Zh a été détectée sur le module Mi surveillé et qu'il est donc nécessaire de déterminer quel est le défaut présent sur ce module.

Cet algorithme comporte les blocs décrits ci-dessous, chacun représentatif de la mise en œuvre d'une étape distincte du procédé de détection de défaut de l'invention.

Il faut noter que si le module Mi comporte plusieurs zones thermiques chaudes Zh distinctes, l'algorithme s'applique pour l'ensemble de ces zones prises en cumulé.

**Bloc B1** - **Etape E1**

Il s'agit de l'étape d'acquisition des données de température, que ce soit à l'aide de la caméra thermique 2 et/ou des capteurs de température et de détermination de la matrice de température. Une température est ainsi affectée à chaque zone thermique de manière à former la matrice de température du module surveillé.

Lors de cette étape, il s'agit également de déterminer la température de référence Tref en exécutant le module d'obtention 36 de la température de référence.

Les différents modules logiciels déjà décrits ci-dessus sont exécutés pour établir la matrice de température du module surveillé défectueux.

**Bloc B2** - **Etape E2**

Cette étape consiste à évaluer l'ampleur de la zone thermique chaude Zh détectée sur le module surveillé. La surface de la zone thermique chaude est déterminée grâce au module de détermination 33 des surfaces respectives des différentes zones thermiques découpées.

Cette étape consiste ainsi à déterminer le rapport de surface $\frac{S_h}{S_{mod}}$ entre la surface $S_h$ occupée par la zone thermique chaude du module surveillé et la surface totale $S_{mod}$ du module. Autrement dit, il s'agit de déterminer le taux d'occupation de chaque zone thermique chaude Zh par rapport à la surface totale $S_{mod}$ du module. La surface totale du module correspond à la surface du module censée recevoir un rayonnement lumineux. Si le module comporte plusieurs zones thermiques chaudes Zh, la surface correspond à celle de toutes les zones thermiques chaudes détectées. Par le terme surface, il faut comprendre la notion géométrique d'aire.

Ce rapport de surface $\frac{S_h}{S_{mod}}$ est comparé avec un coefficient égal à 1/N dans lequel N correspond au nombre de diodes de contournement qui sont présentes dans le module surveillé. Ce nombre N est connu et pré-mémorisé dans les moyens de mémorisation de l'unité de traitement 3. La comparaison est mise en œuvre par un module de comparaison exécuté dans l'unité de traitement.

Cette comparaison permet ainsi de déterminer si la zone thermique chaude Zh impacte un ou plusieurs groupes de cellules (chaque diode de contournement étant associée à un groupe de cellules photovoltaïques - un groupe peut comporter une ou plusieurs cellules).

**Bloc B3** - **Etape E3**

Si la comparaison effectuée à l'étape E2 précédente est négative (branche N), une nouvelle étape de test est mise en œuvre. Un module de test est exécuté dans l'unité de traitement 3.

Cette étape E3 consiste à déterminer si la différence de température $\Delta T_{moy}$ entre la température moyenne du module en défaut et la température moyenne du module de référence Mref, cette température correspondant à la température de référence Tref, dépasse une valeur seuil $V_{TH1}$. La valeur seuil $V_{TH1}$ est par exemple comprise entre 1,8°C et 4°C, avantageusement égale à 2°C.

**Bloc B6** - **Etape E6**

Si la différence de température $\Delta T_{moy}$ déterminée à l'étape E3 est supérieure à la valeur seuil $V_{TH1}$, l'unité de traitement 3 en conclut que l'ensemble du module Mi est défaillant (défaut de 3ème type).

**Bloc B7** - **Etape E7**

Si la différence de température $\Delta T_{moy}$ déterminée à l'étape E3 n'est pas supérieure à la valeur seuil $V_{TH1}$, l'unité de traitement 3 en conclut que le défaut présent est un point chaud (défaut de 1er type).

Après la détection du point chaud, l'unité de traitement 3 peut déterminer la perte de production énergétique $\Delta P$ du module photovoltaïque Mi occasionnée par ce point chaud sur la zone thermique $Z_h$. Cette perte de production énergétique est déterminée à partir de la relation suivante :

$$\Delta P = U_{pv}.S_h.(T_h - T_{ref})$$

Dans laquelle :

- $U_{pv}$ correspond à un coefficient d'échange thermique du module ;
- $S_h$ correspond à la surface de la zone thermique chaude $Z_{ij}$ ;
- $T_h$ correspond à la température de la zone thermique chaude $Z_{ij}$ ;
- $T_{ref}$ correspond à la température de référence du module de référence ;

Un module de calcul est alors exécuté dans l'unité de traitement 3 pour calculer cette perte énergétique.

Concernant le calcul de la perte énergétique, des informations complémentaires sont disponibles dans la demande de brevet WO2016/189052A1, incorporée ici par référence.

**Bloc B4** - **Etape E4**

Si la comparaison effectuée à l'étape E2 est positive (branche Y), une nouvelle étape de test est mise en œuvre. Un nouveau module de test est alors exécuté dans l'unité de traitement 3.

Cette étape de test consiste à vérifier si la température maximale $T_{max}$ de la zone thermique chaude est supérieure à une valeur seuil $V_{TH2}$.

Cette valeur seuil $V_{TH2}$ est choisie supérieure à la température de référence Tref du module de référence Mref, par exemple égale à une valeur comprise entre 110% et 140%, idéalement 130%, de ladite température de référence du module de référence Mref.

**Bloc B5** - **Etape E5**

Si la comparaison effectuée à l'étape E4 est positive (branche Y), l'unité de traitement 3 conclut à une défaillance du module Mi dans sa globalité (défaut de 3ème type)

**Bloc B8** - **Etape E8**

Si la comparaison effectuée à l'étape E4 est négative (branche N), l'unité de traitement exécute un module spécifique sous la forme d'une boucle. Cette boucle permet de déterminer le nombre de diodes de contournement Db qui sont défaillantes. Cette boucle consiste à comparer à chaque itération le rapport de surface $\frac{S_h}{S_{mod}}$ défini ci-dessus à l'étape E2 avec un ratio évolutif égal à n/N dans lequel n correspond au nombre de diodes de contournement et est incrémenté d'une unité à chaque itération jusqu'à N-1, N correspondant au nombre total de diodes de contournement dans le module surveillé.

La boucle est exécutée tant que l'égalité $\frac{S_h}{S_{mod}} = \frac{n}{N}$ est vérifiée et tant que n n'est pas égale à N.

**Bloc B9** - **Etape E9**

Lorsque l'égalité définie à l'étape E8 est vérifiée (branche Y) et que n est inférieur ou égal à N-1, l'unité de traitement 3 en conclut qu'il existe un nombre n de diodes défaillantes (défaut de 2ème type). L'unité de traitement 3 peut en déduire la perte de production énergétique occasionnée par la défaillance des n diodes de contournement.

**Bloc B10** - **Etape E10**

Si l'égalité définie à l'étape E8 n'est jamais vérifiée (branche N) et que n=N, l'unité de traitement en conclut que le module est défaillant dans sa globalité (défaut de 3ème type).

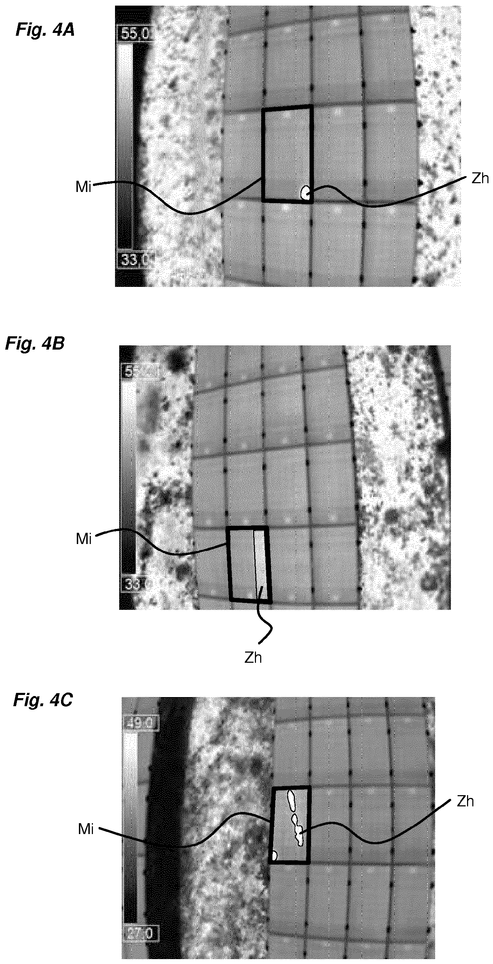

Les figures 4A à 4C représentent trois exemples de défauts présents sur un module photovoltaïque.

Sur la figure 4A, il s'agit d'un défaut de 1er type, c'est-à-dire de type point chaud. La surface $S_h$ de la zone thermique chaude Zh représente 5% de la surface totale $S_{mod}$ du module Mi. La différence de température $\Delta T_{moy}$ est de 1°C et donc inférieure à la valeur seuil $V_{TH1}$. La température maximale $T_{max}$ de la zone thermique chaude est de 180% la température moyenne du module de référence Mref, donc supérieure à la valeur seuil $V_{TH2}$. En appliquant l'algorithme ci-dessus, l'unité de traitement 3 parviendra à l'étape E7, concluant qu'il s'agit bien d'un point chaud.

Sur la figure 4B, il s'agit d'un défaut de 2ème type, c'est-à-dire de type diode de contournement défaillante. La surface $S_h$ de la zone thermique chaude Zh représente 33% de la surface totale $S_{mod}$ du module Mi. La température maximale $T_{max}$ de la zone thermique chaude est inférieure à la valeur seuil $V_{TH2}$. En appliquant l'algorithme ci-dessus, l'unité de traitement 3 parviendra à l'étape E9, concluant qu'il s'agit d'une diode de contournement en défaut.

Sur la figure 4C, il s'agit d'un défaut de 3ème type, c'est-à-dire de type module défaillant dans sa totalité. La surface $S_h$ de la zone thermique chaude Zh représente 35% de la surface totale $S_{mod}$ du module Mi. Dans cet exemple, on peut voir que le module comporte même plusieurs zones thermiques chaudes distinctes. La différence de température $\Delta T_{moy}$ est de 3,29°C et donc supérieure à la valeur seuil $V_{TH1}$. En appliquant l'algorithme ci-dessus, l'unité de traitement 3 parviendra à l'étape E6, concluant qu'il s'agit d'un module défaillant dans sa totalité. Le module est déconnecté de la chaîne.

Selon un aspect particulier de l'invention, en fonction du type de défaut détecté, une action spécifique peut être enclenchée. Il peut s'agit d'une alerte informant un opérateur du type de défaut détecté et indiquant l'action à entreprendre pour effacer ce défaut.

L'invention décrite ci-dessus, relative à la détection de défaut dans un module photovoltaïque, présente ainsi de nombreux avantages, parmi lesquels :

- Une facilité de mise en œuvre, notamment en utilisant une simple caméra thermique pour capturer une image thermique du module. Aucun capteur de courant ou de tension n'est nécessaire ;
- Une solution fiable. Des résultats expérimentaux ont permis de constater que les pertes énergétiques déterminées grâce à la solution de l'invention étaient similaires à celles déterminées par une méthode classique basée sur une analyse de courbes I-V. Ces résultats se sont avérés convaincants quel que soit le type de défaut affectant le module photovoltaïque ;
- Une solution simple, car ne nécessitant qu'un minimum de traitement. Une fois une image thermique du module photovoltaïque acquise, l'algorithme à exécuter est particulièrement simple.
- Une solution aboutie en ce qu'elle permet également de déterminer la perte de production énergétique occasionnée par chaque type de défaut détecté.

## Revendications

1. Procédé de détection de défaut dans un module photovoltaïque (Mi) qui comporte plusieurs cellules photovoltaïques connectées entre elles et une ou plusieurs diodes de contournement, chaque diode de contournement (Db) étant configurée pour contourner une ou plusieurs cellules photovoltaïques dudit module photovoltaïque, **caractérisé en ce qu'**il comporte les étapes suivantes :

   - Détermination d'une matrice de températures du module photovoltaïque (Mi), ladite matrice étant obtenue après découpage du module en plusieurs zones thermiques et affectation d'une température à chaque zone thermique ;
   - Détection d'au moins une zone thermique chaude (Zh) parmi lesdites plusieurs zones du module ;
   - Détermination d'un rapport de surface entre la surface ($S_h$) de la zone thermique chaude (Zh) détectée et la surface totale ($S_{mod}$) du module ;
   - Première comparaison dudit rapport de surface avec un coefficient fonction du nombre de diodes de contournement présentes dans le module ;
   - Détermination du type de défaut à partir du résultat obtenu lors de ladite première comparaison.

2. Procédé selon la revendication 1, **caractérisé en ce que** ladite première comparaison consiste à comparer ledit rapport de surface avec ledit coefficient égal à 1/N dans lequel N correspond au nombre de diodes de contournement présentes dans le module en vue d'obtenir une première option ou une deuxième option selon ledit résultat de la comparaison.

3. Procédé selon la revendication 2, **caractérisé en ce que**, dans ladite première option, il comporte des étapes de :

   - Détermination d'une différence de température ($\Delta T_{moy}$) entre ladite température moyenne du module photovoltaïque et une température de référence (Tref) obtenue sur un module photovoltaïque de référence (Mref) ;
   - Deuxième comparaison de ladite différence de température ($\Delta T_{moy}$) avec une valeur seuil ($V_{TH1}$) ;
   - Détermination du type de défaut à partir du résultat de ladite deuxième comparaison entre une défaillance globale du module et un défaut de type point chaud.

4. Procédé selon la revendication 3, **caractérisé en ce que** lorsque le défaut est de type point chaud, le procédé consiste à déterminer une perte de production ($\Delta P$) énergétique du module photovoltaïque occasionnée par ledit défaut de type point chaud.

5. Procédé selon la revendication 2, **caractérisé en ce que**, dans ladite deuxième option, il comporte des étapes de :

   - Obtention d'une température maximale ($T_{max}$) de ladite zone thermique chaude (Zh) détectée ;
   - Troisième comparaison de ladite température maximale ($T_{max}$) avec une valeur seuil ($V_{TH2}$) supérieure à une valeur moyenne des températures dudit module de référence (Mref) ;
   - Détermination du type de défaut à partir du résultat de ladite troisième comparaison entre une défaillance globale du module et un autre type de défaut.

6. Procédé selon la revendication 5, **caractérisé en ce que** lorsqu'il s'agit d'un autre type de défaut, il comporte une étape de détermination du nombre (n) de diodes de contournement en défaut.

7. Système de détection de défaut dans un module photovoltaïque qui comporte plusieurs cellules photovoltaïques connectées entre elles et une ou plusieurs diodes de contournement, chaque diode de contournement étant configurée pour contourner une ou plusieurs cellules photovoltaïques dudit module photovoltaïque, **caractérisé en ce qu'**il comporte :

   - Un module de détermination d'une matrice de températures du module photovoltaïques, ladite matrice étant obtenue après découpage du module en plusieurs zones thermiques et affectation d'une température à chaque zone thermique ;
   - Un module de détection d'au moins une zone thermique chaude (Zh) parmi lesdites plusieurs zones du module ;
   - Un module de détermination d'un rapport de surface entre la surface ($S_h$) de la zone thermique chaude (Zh) détectée et la surface totale ($S_{mod}$) du module (Mi);
   - Un premier module de comparaison configuré pour mettre en œuvre une comparaison dudit rapport de surface avec un coefficient fonction du nombre (N) de diodes de contournement présentes dans le module ;
   - Un module de détermination du type de défaut à partir du résultat obtenu par ledit premier module de comparaison.

8. Système selon la revendication 7, **caractérisé en**

ce que ledit premier module de comparaison est configuré pour comparer ledit rapport de surface avec ledit coefficient égal à 1/N dans lequel N correspond au nombre de diodes de contournement présentes dans le module en vue d'obtenir une première option ou une deuxième option selon ledit résultat de la comparaison.

9. Système selon la revendication 8, **caractérisé en ce que**, dans ladite première option, il est configuré pour exécuter :

- Un module de détermination d'une différence de température ($\Delta T_{moy}$) entre une température moyenne du module photovoltaïque et une température de référence (Tref) obtenue sur un module photovoltaïque de référence (Mref) ;
- Un deuxième module de comparaison configuré pour mettre en œuvre une comparaison de ladite différence de température ($\Delta T_{moy}$) avec une valeur seuil ($V_{TH1}$) ;
- Un module de détermination du type de défaut à partir du résultat de ladite comparaison mise en œuvre par ledit deuxième module de comparaison, entre une défaillance globale du module et un défaut de type point chaud.

10. Système selon la revendication 9, **caractérisé en ce que** lorsque le défaut est de type point chaud, le système est configuré pour exécuter un module de détermination d'une perte de production énergétique du module photovoltaïque occasionnée par ledit défaut de type point chaud.

11. Système selon la revendication 8, **caractérisé en ce que**, dans ladite deuxième option, le système est configuré pour exécuter :

- Un module d'obtention d'une température maximale ($T_{max}$) de ladite zone chaude détectée ;
- Un troisième module de comparaison configuré pour mettre en œuvre une comparaison de ladite température maximale avec une valeur seuil ($V_{TH2}$) supérieure à une valeur moyenne des températures dudit module de référence (Mref) ;
- Un module de détermination du type de défaut à partir du résultat de ladite comparaison mise en œuvre par ledit troisième module de comparaison, entre une défaillance globale du module et un autre type de défaut.

12. Système selon la revendication 11, **caractérisé en ce que** lorsqu'il s'agit d'un autre type de défaut, le système est configuré pour exécuter un module de détermination du nombre (n) de diodes de contournement en défaut.

**Patentansprüche**

1. Verfahren zur Fehlererkennung in einem Photovoltaikmodul (Mi), welches mehrere miteinander verbundene Solarzellen und eine oder mehrere Bypassdioden umfasst, wobei jede Bypassdiode (Db) dafür ausgelegt ist, eine oder mehrere Solarzellen des Photovoltaikmoduls zu umgehen, **dadurch gekennzeichnet, dass** es die folgenden Schritte umfasst:

- Bestimmung einer Matrix von Temperaturen des Photovoltaikmoduls (Mi), wobei die Matrix nach Zerlegung des Moduls in mehrere thermische Bereiche und Zuweisung einer Temperatur zu jedem thermischen Bereich erhalten wird;
- Erkennung wenigstens eines heißen thermischen Bereichs (Zh) unter den mehreren Bereichen des Moduls;
- Bestimmung eines Flächenverhältnisses zwischen der Fläche ($S_h$) des erkannten heißen thermischen Bereichs (Zh) und der Gesamtfläche ($S_{mod}$) des Moduls;
- erster Vergleich des Flächenverhältnisses mit einem Koeffizienten, der von der Anzahl der in dem Modul vorhandenen Bypassdioden abhängt;
- Bestimmung des Fehlertyps anhand des bei dem ersten Vergleich erhaltenen Ergebnisses.

2. Verfahren nach Anspruch 1, **dadurch gekennzeichnet, dass** der erste Vergleich darin besteht, das Flächenverhältnis mit dem Koeffizienten zu vergleichen, der gleich 1/N ist, wobei N der Anzahl der in dem Modul vorhandenen Bypassdioden entspricht, um je nach dem Ergebnis des Vergleichs eine erste Option oder eine zweite Option zu erhalten.

3. Verfahren nach Anspruch 2, **dadurch gekennzeichnet, dass** es bei der ersten Option die Schritte umfasst:

- Bestimmung einer Temperaturdifferenz ($\Delta T_{moy}$) zwischen der mittleren Temperatur des Photovoltaikmoduls und einer Referenztemperatur (Tref), die an einem Referenz-Photovoltaikmodul (Mref) erhalten wurde;
- zweiter Vergleich der Temperaturdifferenz ($\Delta T_{moy}$) mit einem Schwellenwert ($V_{TH1}$);
- Bestimmung des Fehlertyps anhand des Ergebnisses des zweiten Vergleichs als vollständiger Ausfall des Moduls oder als Fehler vom Typ eines Hot Spots.

4. Verfahren nach Anspruch 3, **dadurch gekennzeichnet, dass**, wenn der Fehler vom Typ eines Hot Spots ist, das Verfahren darin besteht, einen Verlust an Energieerzeugung ($\Delta P$) des Photovoltaikmoduls zu bestimmen, der durch den Fehler vom Typ eines Hot Spots verursacht wurde.

5. Verfahren nach Anspruch 2, **dadurch gekennzeichnet, dass** es bei der zweiten Option die Schritte umfasst:

- Gewinnung einer maximalen Temperatur ($T_{max}$) des erkannten heißen thermischen Bereichs (Zh);
- dritter Vergleich der maximalen Temperatur ($T_{max}$) mit einem Schwellenwert ($V_{TH2}$), der größer als ein Mittelwert der Temperaturen des Referenzmoduls (Mref) ist;
- Bestimmung des Fehlertyps anhand des Ergebnisses des dritten Vergleichs als vollständiger Ausfall des Moduls oder als Fehler eines anderen Typs.

6. Verfahren nach Anspruch 5, **dadurch gekennzeichnet, dass** es, wenn es sich um einen Fehler eines anderen Typs handelt, einen Schritt der Bestimmung der Anzahl (n) der fehlerhaften Bypassdioden umfasst.

7. System zur Fehlererkennung in einem Photovoltaikmodul, welches mehrere miteinander verbundene Solarzellen und eine oder mehrere Bypassdioden umfasst, wobei jede Bypassdiode dafür ausgelegt ist, eine oder mehrere Solarzellen des Photovoltaikmoduls zu umgehen, **dadurch gekennzeichnet, dass** es umfasst:

- ein Modul zur Bestimmung einer Matrix von Temperaturen des Photovoltaikmoduls, wobei die Matrix nach Zerlegung des Moduls in mehrere thermische Bereiche und Zuweisung einer Temperatur zu jedem thermischen Bereich erhalten wird;
- ein Modul zur Erkennung wenigstens eines heißen thermischen Bereichs (Zh) unter den mehreren Bereichen des Moduls;
- ein Modul zur Bestimmung eines Flächenverhältnisses zwischen der Fläche ($S_h$) des erkannten heißen thermischen Bereichs (Zh) und der Gesamtfläche ($S_{mod}$) des Moduls (Mi);
- ein erstes Vergleichsmodul, das dafür ausgelegt ist, einen Vergleich des Flächenverhältnisses mit einem Koeffizienten durchzuführen, der von der Anzahl (N) der in dem Modul vorhandenen Bypassdioden abhängt;
- ein Modul zur Bestimmung des Fehlertyps anhand des von dem ersten Vergleichsmodul erhaltenen Ergebnisses.

8. System nach Anspruch 7, **dadurch gekennzeich-** net, dass das erste Vergleichsmodul dafür ausgelegt ist, das Flächenverhältnis mit dem Koeffizienten zu vergleichen, der gleich 1/N ist, wobei N der Anzahl der in dem Modul vorhandenen Bypassdioden entspricht, um je nach dem Ergebnis des Vergleichs eine erste Option oder eine zweite Option zu erhalten.

9. System nach Anspruch 8, **dadurch gekennzeichnet, dass** es bei der ersten Option dafür ausgelegt ist auszuführen:

- ein Modul zur Bestimmung einer Temperaturdifferenz ($\Delta T_{moy}$) zwischen einer mittleren Temperatur des Photovoltaikmoduls und einer Referenztemperatur (Tref), die an einem Referenz-Photovoltaikmodul (Mref) erhalten wurde;
- ein zweites Vergleichsmodul, das dafür ausgelegt ist, einen Vergleich der Temperaturdifferenz ($\Delta T_{moy}$) mit einem Schwellenwert ($V_{TH1}$) durchzuführen;
- ein Modul zur Bestimmung des Fehlertyps anhand des Ergebnisses des von dem zweiten Vergleichsmodul durchgeführten Vergleichs als vollständiger Ausfall des Moduls oder als Fehler vom Typ eines Hot Spots.

10. System nach Anspruch 9, **dadurch gekennzeichnet, dass**, wenn der Fehler vom Typ eines Hot Spots ist, das System dafür ausgelegt ist, ein Modul zur Bestimmung eines Verlusts an Energieerzeugung des Photovoltaikmoduls, der durch den Fehler vom Typ eines Hot Spots verursacht wurde, auszuführen.

11. System nach Anspruch 8, **dadurch gekennzeichnet, dass** bei der zweiten Option das System dafür ausgelegt ist auszuführen:

- ein Modul zur Gewinnung einer maximalen Temperatur ($T_{max}$) des erkannten heißen Bereichs;
- ein drittes Vergleichsmodul, das dafür ausgelegt ist, einen Vergleich der maximalen Temperatur mit einem Schwellenwert ($V_{TH2}$) durchzuführen, der größer als ein Mittelwert der Temperaturen des Referenzmoduls (Mref) ist;
- ein Modul zur Bestimmung des Fehlertyps anhand des Ergebnisses des von dem zweiten Vergleichsmodul durchgeführten Vergleichs als vollständiger Ausfall des Moduls oder als Fehler eines anderen Typs.

12. System nach Anspruch 11, **dadurch gekennzeichnet, dass**, wenn es sich um einen Fehler eines anderen Typs handelt, das System dafür ausgelegt ist, ein Modul zur Bestimmung der Anzahl (n) der fehlerhaften Bypassdioden auszuführen.

**Claims**

1.  Method for detecting a fault in a photovoltaic module (Mi) that includes a plurality of photovoltaic cells connected to one another and one or more bypass diodes, each bypass diode (Db) being configured to bypass one or more photovoltaic cells of said photovoltaic module, **characterized in that** it includes the following steps:

    - Determining a matrix of temperatures of the photovoltaic module (Mi), said matrix being obtained after dividing the module into a plurality of thermal zones and assigning a temperature to each thermal zone;
    - Detecting at least one hot thermal zone (Zh) from among said plurality of zones of the module;
    - Determining a surface area ratio between the surface area ($S_h$) of the detected hot thermal zone (Zh) and the total surface area ($S_{mod}$) of the module;
    - A first comparison of said surface area ratio with a coefficient dependent on the number of bypass diodes present in the module;
    - Determining the type of fault from the result obtained in said first comparison.

2.  Method according to Claim 1, **characterized in that** said first comparison consists in comparing said surface area ratio with said coefficient equal to 1/N, wherein N corresponds to the number of bypass diodes present in the module, for the purpose of obtaining a first option or a second option according to said result of the comparison.

3.  Method according to Claim 2, **characterized in that**, in said first option, it includes steps of:

    - Determining a temperature difference ($\Delta T_{av}$) between said average temperature of the photovoltaic module and a reference temperature (Tref) obtained on a reference photovoltaic module (Mref);
    - A second comparison of said temperature difference ($\Delta T_{av}$) with a threshold value ($V_{TH1}$);
    - Determining the type of fault from the result of said second comparison between an overall failure of the module and a hotspot fault.

4.  Method according to Claim 3, **characterized in that**, when the fault is a hotspot fault, the method consists in determining an energy production loss ($\Delta P$) of the photovoltaic module caused by said hotspot fault.

5.  Method according to Claim 2, **characterized in that**, in said second option, it includes steps of:

    - Obtaining a maximum temperature ($T_{max}$) of said detected hot thermal zone (Zh);
    - A third comparison of said maximum temperature ($T_{max}$) with a threshold value ($V_{TH2}$) greater than an average value of the temperatures of said reference module (Mref);
    - Determining the type of fault from the result of said third comparison between an overall failure of the module and another type of fault.

6.  Method according to Claim 5, **characterized in that**, when another type of fault is involved, it includes a step of determining the number (n) of faulty bypass diodes.

7.  System for detecting a fault in a photovoltaic module that includes a plurality of photovoltaic cells connected to one another and one or more bypass diodes, each bypass diode being configured to bypass one or more photovoltaic cells of said photovoltaic module, **characterized in that** it includes:

    - A module for determining a matrix of temperatures of the photovoltaic module, said matrix being obtained after dividing the module into a plurality of thermal zones and assigning a temperature to each thermal zone;
    - A module for detecting at least one hot thermal zone (Zh) from among said plurality of zones of the module;
    - A module for determining a surface area ratio between the surface area ($S_h$) of the detected hot thermal zone (Zh) and the total surface area ($S_{mod}$) of the module (Mi);
    - A first comparison module configured to implement a comparison of said surface area ratio with a coefficient dependent on the number (N) of bypass diodes present in the module;
    - A module for determining the type of fault from the result obtained by said first comparison module.

8.  System according to Claim 7, **characterized in that** said first comparison module is configured to compare said surface area ratio with said coefficient equal to 1/N, wherein N corresponds to the number of bypass diodes present in the module, for the purpose of obtaining a first option or a second option according to said result of the comparison.

9.  System according to Claim 8, **characterized in that**, in said first option, it is configured to execute:

    - A module for determining a temperature difference ($\Delta T_{av}$) between an average temperature of the photovoltaic module and a reference temperature (Tref) obtained on a reference photovoltaic module (Mref);

- A second comparison module configured to implement a comparison of said temperature difference ($\Delta T_{av}$) with a threshold value ($V_{TH1}$);
- A module for determining the type of fault from the result of said comparison implemented by said second comparison module, between an overall failure of the module and a hotspot fault.

10. System according to Claim 9, **characterized in that**, when the fault is a hotspot fault, the system is configured to execute a module for determining an energy production loss of the photovoltaic module caused by said hotspot fault.

11. System according to Claim 8, **characterized in that**, in said second option, the system is configured to execute:

- A module for obtaining a maximum temperature ($T_{max}$) of said detected hot zone;
- A third comparison module configured to implement a comparison of said maximum temperature with a threshold value ($V_{TH2}$) greater than an average value of the temperatures of said reference module (Mref);
- A module for determining the type of fault from the result of said comparison implemented by said third comparison module, between an overall failure of the module and another type of fault.

12. System according to Claim 11, **characterized in that**, when another type of fault is involved, the system is configured to execute a module for determining the number (n) of faulty bypass diodes.

Fig. 1

**Fig. 2**

*Fig. 3*

B1

E1

B2

$\boxed{Y}$    E2
$\dfrac{S_h}{S_{\text{mod}}} > 1\,/\,N$    $\boxed{N}$

B3

E3
$\boxed{Y}$    $\Delta T_{moy} > V_{TH1}$    $\boxed{N}$

B4

E4
$\boxed{Y}$    $T_{\max} > V_{TH2}$    $\boxed{N}$

B5

E5

n=1 à N-1

B6

E6

B7

E7

n/N

$\Delta P$

B8

E8
$\dfrac{S_h}{S_{\text{mod}}} = n\,/\,N$    $\boxed{Y}$

$\boxed{N}$

B9

E9

$\boxed{N}$    n=N    $\boxed{Y}$

B10

E10

**Fig. 4A**

**Fig. 4B**

**Fig. 4C**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 2015118608 A
- US 6512458 B1
- US 2011088744 A1
- US 2011316343 A1
- WO 2016189052 A1